# EUROPÄISCHE PATENTSCHRIFT

(11) **EP 2 647 043 B1**
(45) Veröffentlichungstag und Bekanntmachung des Hinweises auf die Patenterteilung: **14.04.2021**
(21) Anmeldenummer: 11788538.4
(22) Anmeldetag: 30.11.2011
(51) Int. Cl.: H01L 21/67

(54) **VERFAHREN ZUM BEHANDELN VON WAFERN UND MIKROPLÄTTCHEN**
METHOD FOR TREATING WAFERS AND DIES
PROCÉDÉ DE TRAITEMENT DE TRANCHES ET DE MICROPLAQUETTES

(30) Priorität: 30.11.2010 DE 102010062166
(43) Veröffentlichungstag der Anmeldung: 09.10.2013
(73) Patentinhaber: Nissan Chemical Corporation, Tokyo (JP)
(72) Erfinder: PIEKASS, Madeleine, 86415 Mering (DE); PAMLER, Werner, 80686 München (DE); GROSS, Andreas, 83703 Gmund a. Tegernsee (DE); LUIBLE, Andreas, 88045 Friedrichshafen (DE); RICHTER, Franz, 82223 Eichenau (DE)
(74) Vertreter: Eisenführ Speiser
(86) Internationale Anmeldenummer: PCT/EP2011/071434
(87) Internationale Veröffentlichungsnummer: WO 2012/072706

(56) Entgegenhaltungen:
- JP-A- 2010 157 531
- US-A- 4 086 870
- US-A- 5 556 503
- US-A1- 2006 185 695
- US-A1- 2009 173 358
- US-A1- 2009 305 617

## Beschreibung

Die Erfindung betrifft ein Verfahren zum Behandeln einer Fläche auf einem Wafer oder einem Mikroplättchen, eine Vorrichtung zum Durchführen dieses Behandelns und einen speziellen Ring, der für ein entsprechendes Verfahren ausgestaltet ist.

Beim Bearbeiten von Wafern, insbesondere solchen, die elektronische Bauteile tragen, sind häufig Reinigungsschritte oder Schritte zur Oberflächenmodifizierung von (Teil-)Flächen notwendig. So ist beispielsweise beim Dünnen eines Wafers ein Reinigungsschritt erforderlich, der Reste des abgetragenen Materials von der Waferoberfläche entfernt. Oft sind auch Oberflächenmodifizierungen von Teilbereichen der Oberfläche des Wafers wünschenswert oder erforderlich, um die Oberfläche für nachfolgende Prozessschritte vorzubereiten, z. B. um die Oberfläche in (Teil-)Bereichen hydrophil zu machen.

Häufig sind Wafer während der Bearbeitung auf eine in der Halbleiterindustrie übliche Folie auflaminiert. In solchen Fällen ist die Folie selbst regelmäßig auf einen Rahmen gespannt und während für einen nicht-auflaminierten Wafer bzw. entsprechende Mikroplättchen beim Reinigen oder bei der Oberflächenmodifizierung ein Tauchen in einem Tauchbad die Lösung der Wahl sein kann, kann das Bearbeiten eines auflaminierten Wafers oder entsprechender Mikroplättchen mit flüssigen Behandlungsmitteln nur eingeschränkt möglich sein. Dies kann zum Beispiel an der Unverträglichkeit der Behandlungsmittel mit der Folie und/oder dem diese Folie tragenden Rahmen liegen.

US 2006/185695 A1 offenbart ein Verfahren zum Reinigen eines Wafers bei dem es aufwändig ist, die eingesetzte Behandlungsflüssigkeit zu entfernen

Aufgabe der vorliegenden Erfindung war es daher, ein schonendes Verfahren zum Behandeln einer Fläche auf einem Wafer oder einem Mikroplättchen anzugeben, bei dem insbesondere die Einwirkfläche einer Behandlungsflüssigkeit auf einfache Art und Weise kontrolliert und die Behandlungsflüssigkeit effektiv wieder entfernt werden kann. Ferner war es bevorzugt wünschenswert, dass im Rahmen des erfindungsgemäßen Verfahrens auch Teilflächen auf einem Wafer (und sogar einem Mikroplättchen) selektiv mit Flüssigkeiten behandelt werden können. Gleichzeitig war es bevorzugt wünschenswert, dass sich das erfindungsgemäße Verfahren in übliche Prozesse bei der Bearbeitung von Wafern gut einbinden lässt, dass die Behandlungsgeschwindigkeit erhöht wird und/oder dass Behandlungsmittel gespart werden kann.

Diese Aufgabe wird erfindungsgemäß gelöst durch ein Verfahren zum Behandeln einer Fläche auf einem Wafer oder einem Mikroplättchen gemäß Anspruch 1.

Unter einer Fläche im Sinne der vorliegenden Erfindung ist entweder eine vollständige oder eine Teilfläche zu verstehen. Sofern es sich bei dem zu reinigenden Gegenstand um einen Wafer handelt, besitzt dieser im Prinzip drei Flächen, nämlich a) eine Rückseite, b) eine Vorderseite (auf der ggf. die elektronischen Bauteile vorgesehen sind) und c) eine umlaufende Randfläche, die sich entlang des Umfanges um den Wafer zieht, sofern der Wafer kreisförmig ist. Der Fachmann kann diese Definitionen selbstverständlich analog übertragen auf Mikroplättchen bzw. auch nicht-runde Wafer.

Im Sinne des erfindungsgemäßen Verfahrens ist es daher eingeschlossen, dass auch mehr als eine der Flächen des zu reinigenden Gegenstand behandelt werden.

Ein Verfahren im Sinne der Erfindung erfolgt so, dass unter den gegebenen Prozessbedingungen, eine Behandlungsflüssigkeit nicht unkontrolliert aus der Vertiefung austritt. Dies kann durch Kleben, mechanisches Fixieren, Ansaugen durch Unterdruck oder durch Gewichtskraft des umlaufenden Materials oder Kraft, die auf dieses umlaufende Material ausgeübt wird, erfolgen. Der Fachmann kann in diesem Zusammenhang weitere Ausgestaltungsmöglichkeiten des Anbringens des Materials ohne Schwierigkeiten den jeweiligen Anforderungen entsprechend anpassen.

Eine Behandlung im Sinne der Erfindung umfasst dabei ein Reinigen. Es kann es aber bevorzugt sein, dass eine Behandlung zusätzlich eine Oberflächenmodifikation z. B. im Sinne von einer Hydrophilierung oder Hydrophobisierung ist. Eine nicht erfindungsgemäße Behandlung kann auch das Anbringen einer (ggf. weiteren) Schicht sein. Selbstverständlich ist es im Sinne der Erfindung möglich, mehrere verschiedene Behandlungen (z. B. Reinigen und Hydrophilisieren) parallel oder hintereinander auszuführen.

Es hat sich herausgestellt, dass das erfindungsgemäße Verfahren überraschend gut in übliche Bearbeitungsverfahren für Wafer und Mikroplättchen integrierbar ist. Gleichzeitig ist es vorteilhaft, dass mittels der Vertiefung genau die Angriffsfläche für die Behandlungsflüssigkeit festgelegt wird. Somit lassen sich außerhalb der Vertiefung liegende Bereiche, wie z. B. ein Rahmen auf den eine Folie gespannt ist, die den zu bearbeitenden Wafer / das Mikroplättchen trägt gegenüber der Behandlungsflüssigkeit schützen.

Ferner ist von Vorteil, dass die Einwirkzeit der Behandlungsflüssigkeit kontrolliert und es vermieden wird, dass Behandlungsflüssigkeit nachdosiert werden muss, weil diese unkontrolliert aus dem Bereich austritt, in dem sie wirken soll.

Das Anbringen für die umlaufende Begrenzung kann so erfolgen, dass das Material mit dem behandelten Wafer / Mikroplättchen nicht in Kontakt kommt, so dass eine Vertiefung entsteht, in deren Mitte (ohne Kontakt zum Rand) der zu behandelnde Wafer / das Mikroplättchen liegt (nicht erfindungsgemäß). Erfindungsgemäß ist die umlaufende Begrenzung so anzubringen, dass der Boden der Vertiefung komplett von dem zu behandelnden Wafer / Mikroplättchen gebildet wird. In diesem Falle kommt die Behandlungsflüssigkeit ausschließlich mit dem Wafer / Mikroplättchen und dem Material für die umlaufende Begrenzung in Kontakt, sofern nicht weiter Vorrichtungen oder Vorrichtungsteile gezielt in die entstehende Vertiefung eingebracht werden. Sofern der zu behandelnde Wafer / das zu behandelnde Mikroplättchen den Boden der Vertiefung bildet, ist es bevorzugt, dass das Material für die umlaufende Begrenzung nur 0,2 - 2 mm, bevorzugt 0,5 - 1 mm entlang des Umfanges des Wafers / des Mikroplättchens bedeckt. So ist gewährleistet, dass der wesentliche Teil der Fläche des Wafers / des Mikroplättchens der Behandlung ausgesetzt wird.

Erfindungsgemäß ist es bevorzugt, dass das Material für die umlaufende Begrenzung in Form eines Ringes zur Verfügung gestellt wird. Ein solcher Ring ist leicht auflegbar und bei entsprechender Ausgestaltung, insbesondere in der bevorzugten Form (vergleiche weiter unten) besonders geeignet, eine entsprechende Dichtfunktion und zu gewährleisten.

Wenn in dem nachfolgenden Text von Wafer gesprochen wird, ist der Begriff "Mikroplättchen" mit umfasst, sofern nicht anders explizit angemerkt.

Für die Durchführung des erfindungsgemäßen Verfahrens ist es bevorzugt, dass der zu reinigende Wafer auf einer Folie auflaminiert ist. Bevorzugte Folien in diesem Sinne sind Standard Dicing-Tapes oder Backgrinding Tapes, wie sie bereits heute in den Halbleiter-Produktionsprozessen eingesetzt werden. Konkrete Beispiele sind: Fa. Lintec: Adwill D-175, Adwill D-650, Adwill D-678 oder auch Adwill E-8320; Fa. Ultron: Dicing Tape 1044R; Ahnliche Tapes gibt es von Fa. Nitto Denko.

Diese Folie dient dann als Unterlage im Sinne des Schrittes b) des erfindungsgemäßen Verfahrens. Die Folie selbst ist bevorzugt auf einen Rahmen gespannt und wird (aufgespannt auf den Rahmen) bevorzugt auf eine Halterungsvorrichtung gelegt. Bevorzugt ist es, dass wenigstens Teile der für den Wafer / die Folie vorgesehenen Auflagefläche der Halterungsvorrichtung porös sind, so dass die Folie (und damit auch der auf sie laminierte Wafer) mittels Unterdruck an der Auflagefläche angesaugt und stabilisiert werden kann. Gleichzeitig kann es bevorzugt sein, dass der Rahmen, der die Folie aufspannt, zusätzlich mittels mechanischer Fixierung auf der Vorrichtung gehalten wird.

Erfindungsgemäß ist, dass das Material für die umlaufende Begrenzung in Schritt d) so angebracht ist, dass eine vom oberen Rand der Begrenzung zur zur reinigenden Fläche abfallende Schräge vorhanden ist.

Bevorzugt hat die Schräge einen Neigungswinkel von 30 - 60 °, bevorzugt 40 - 50° und besonders bevorzugt 45°. Dies ermöglicht, dass im Rahmen des erfindungsgemäßen Verfahrens zunächst durch Anbringen des Materials für die umlaufende Begrenzung (bevorzugt in Form eines Ringes) eine Vertiefung erzeugt wird, in die die Behandlungsflüssigkeit eingebracht wird und aus dieser nicht austritt. Nach entsprechender Einwirkzeit ist es dann möglich, dass Behandlungsmittel durch Abschleudern aus der Vertiefung zu entfernen. Hierfür ist es bevorzugt, dass im erfindungsgemäßen Verfahren die gesamte Vertiefung inklusive des Randes (und des Bodens) in eine Rotation versetzt wird, so dass mittels der Fliehkräfte die Behandlungsflüssigkeit aus der Vertiefung geschleudert wird. Dies wird durch eine abfallende Schräge gemäß der bevorzugten Form des Verfahrens unterstützt.

Erfindungsgemäß bevorzugt ist ferner, dass die Behandlungswirkung der Behandlungsflüssigkeit durch Vibration und/oder durch Erwärmung der Behandlungsflüssigkeit verbessert wird.

Bevorzugt ist, dass die Behandlung eine Reinigung umfasst. Insbesondere in diesem bevorzugten Falle ist es erfindungsgemäß weiter bevorzugt, dass die Reinigungswirkung durch einen Ultraschallgeber verstärkt wird, der in die Behandlungsflüssigkeit nach Schritt e) eintaucht. Dieser Ultraschallgeber versetzt die Behandlungsflüssigkeit in Schwingung, so dass sie verstärkt ihre Wirkung entfalten kann.

Sofern erfindungsgemäß eine Erwärmung der Behandlungsflüssigkeit eingesetzt werden soll, ist es möglich, die Behandlungsflüssigkeit bereits vor Kontakt mit der zu behandelnden Fläche zu erwärmen. Es ist aber auch möglich, die Behandlungsflüssigkeit in der Vertiefung durch direktes oder indirektes Beheizen zu erwärmen z. B. mittels IR-Strahlung. Indirektes Beheizen kann auch beispielsweise durch direkte Erhöhung der Temperatur der zu behandelnden Fläche erfolgen. Wie bereits oben angedeutet ist es erfindungsgemäß bevorzugt, dass die Behandlung eine Reinigung ist. Besonders bevorzugt in diesem Zusammenhang ist, dass eine Reinigung von silikonhaltigen Rückständen, insbesondere von silikonölhaltigen Rückständen erfolgt.

Das erfindungsgemäße Verfahren ist auch möglich für Wafer, die sehr stark gedünnt wurden, beispielsweise in einen Bereich von 10 - 50 µm. Darüberhinaus kann das Verfahren auch besonders gut für Wafer eingesetzt werden, die auf eine Dicke von oberhalb 50 µm, z.B. auf Dicken von 50 - 200 µm gedünnt wurden.

Das erfindungsgemäße Verfahren kann auch so ausgestaltet werden, dass zusätzlich zum Abschleudern ein Absaugen der Behandlungsflüssigkeit mittels eines geeigneten Vorrichtungsteiles erfolgt.

Zusätzlich ist es möglich, dass das Entfernen der Behandlungsflüssigkeit wenigstens teilweise durch Ablassen erfolgt. Für diesen Zweck wird der Fachmann im Rahmen der Gesamtanordnung eine Ablassvorrichtung vorsehen, diese kann entweder im Rand der Vertiefung oder im Vertiefungsboden vorgesehen werden, wenn die Vertiefung so ausgestaltet ist, dass nicht nur die reinigende Fläche betroffen ist. Bevorzugt ist eine solche Vorrichtung ein Ventil, an das ein entsprechender Unterdruck zum Absaugen angelegt werden kann oder ein Hahn. Falls die Ablassvorrichtung so ausgestaltet ist, dass ein Unterdruck angelegt wird zum Ablassen wird diese auch als Absaugvorrichtung bezeichnet.

Für das erfindungsgemäße Verfahren kann es ferner bevorzugt sein, dass die Behandlungsflüssigkeit nach dem Einwirken so aufgefangen wird, dass sie einer Wiederverwertung zugeführt werden kann.

Weiterhin kann es im erfindungsgemäßen Verfahren bevorzugt sein, dass die zu reinigende Fläche mittels einer Düse durch Druckluft, Inertgas oder andere geeignete Gase getrocknet wird.

Als weitere Schritte im erfindungsgemäßen Rahmen der Flächenbehandlung kann es bevorzugt sein, dass in die Vertiefung nach der eigentlichen Behandlung einmal oder mehrfach Spülflüssigkeiten eingebracht werden, um eventuelle Reste der Behandlungsflüssigkeit zu entfernen. Bevorzugte Spülflüssigkeiten in diesem Sinne sind organische Lösungsmittel wie Isopropanol, Ethanol, Aceton oder auch Benzinfraktionen sowie eventuell mit Additiven wie Detergenzien versetztes Wasser.

Erfindungsgemäß einzusetzende Behandlungsflüssigkeiten sind z. B. organische Lösungsmittel zum Quellen oder Lösen von auf Wafern befindlichen Polymeren wie NMP, Ethylacetat, DMSO, Acetone, Benzinfraktionen oder Alkohole, basische Lösungen wie wässrige Natriumhydroxid, Kaliumhydroxidlösungen oder wässrige oder alkoholische Lösungen von Tetramethylammoniumhydroxid, Lösungen zur Oxidation von Metall- und Halbmetalloberflächen wie Salpetersäure, fluoridhaltige Lösungen wie Flußsäure, Tetrabutylammoniumfluorid in Butanon oder Kaliumfluorid in Dimethylcarbonat oder auf Polydimethylsiloxanen basierende Zubereitungen, die Zusätze wie organische Lösungsmittel wie Ethylacetat, Hexan oder Benzinfraktionen und/oder Katalysatoren wie Phosphornitrilchlorid und dessen Derivate und/oder Edelmetall-Katalysatoren enthalten.

Passend für die Erfindung ist eine Vorrichtung, die eingerichtet ist zur Durchführung eines erfindungsgemäßen Verfahrens, insbesondere auch in seinen bevorzugten Varianten. Hierzu gehört, dass diese Vorrichtung insbesondere in der Lage ist, dass Anbringen des Materials für umlaufende Begrenzung so durchzuführen, dass eine Vertiefung für eine Behandlungsflüssigkeit entsteht, aus der die Behandlungsflüssigkeit nicht austritt.

Ferner ist Teil der Erfindung ist ein speziell ausgebildeter Ring für ein erfindungsgemäßes Verfahren, wobei der Ring eine vom oberen Rand nach innen schräg abfallende, umlaufende Fläche umfasst und im Bereich des unteren Randes der schräg abfallenden, umlaufenden Fläche eine Ausgestaltung zum Abdichten umfasst.

Die Ausgestaltung zum Abdichten ist bevorzugt eine umlaufende Kante, die an dem Innenumfang des Ringes gegenüber der Unterseite vorspringt. Die Breite dieser umlaufenden Kante ist bevorzugt 0,5 - 5mm, besonders bevorzugt 0,7 - 2 mm.

Alternativ, aber nicht dem erfindungsgemäüßen Ring entsprechend, ist dass der Ring so ausgestaltet ist, dass in ihn im Bereich der Unterseite und innen umlaufend eine O-Ring-Dichtung eingebracht ist. In diesem Falle erfolgt eine Abdichtung durch den O-Ring. Als Dichtmaterialien hierfür eignen sich alle elastischen Materialien, die eine mit dem verwendeten Reinigungsmittel chemische Verträglichkeit aufweisen.

Alternativ oder zusätzlich zu O-Ring-Dichtungen können Dichtlippen oder Dichtungen mit anderen Querschnittformen in Betracht kommen, der Fachmann wird hier eine angemessene Wahl treffen.

Bevorzugte Ausgestaltungen des erfindungsgemäßen Ringes, der Dichtlippen und der Nut, in der sich die O-Ring-Dichtung befindet, sind auch aus den Figuren zu entnehmen.

Der Dichtvorgang kann gewährleistet werden, durch Druck, der auf den erfindungsgemäßen Ring ausgeübt wird. Der Dichteffekt kann dabei durch geeignete Materialwahl für den Ring gesteigert werden. In vielen Fällen wird eine Abdichtung auch dadurch unterstützt, dass die zu reinigende Fläche (bzw. der zugehörige Wafer) auf eine elastische Folie auflaminiert ist. Diese elastische Folie gibt bei Krafteinwirkung durch den Ring etwas nach, so dass der Dichteffekt unterstützt wird.

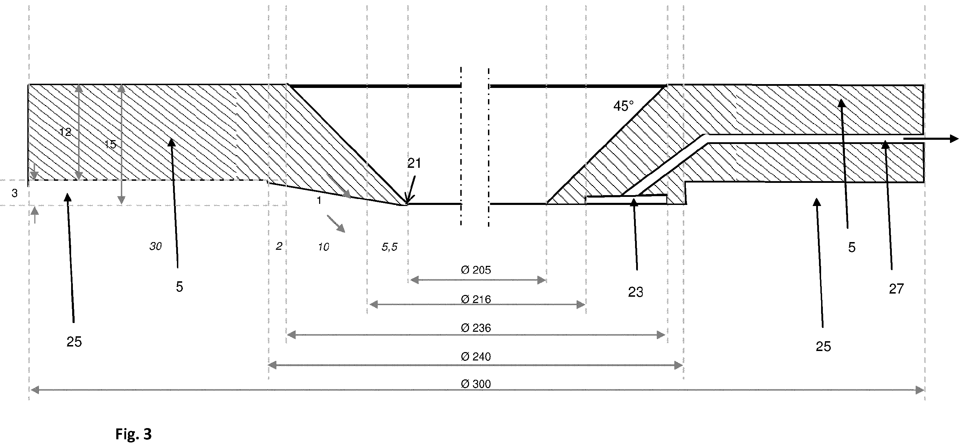

Besondere Merkmale des erfindungsgemäßen Ringes werden in der Beschreibung zu Fig, 2. und Fig. 3 erläutert.

Nachfolgend wird die Erfindung anhand von Figuren näher erläutert.

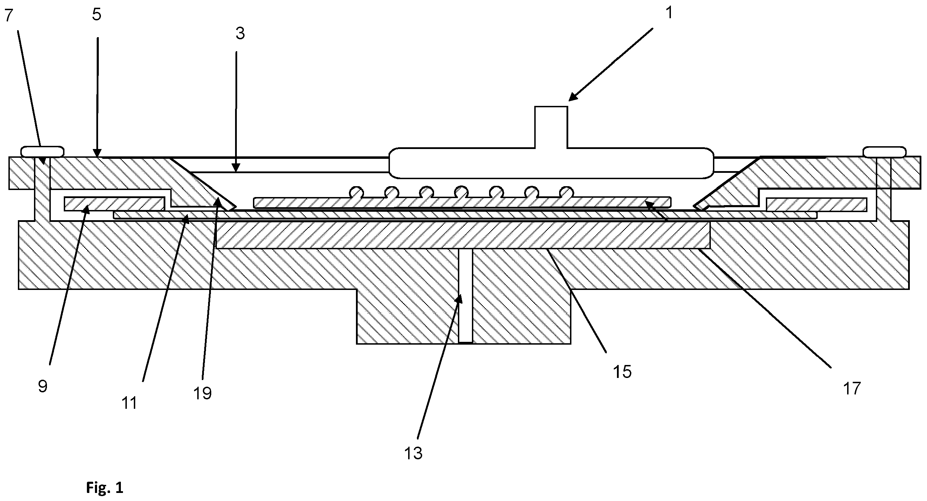

Dabei stellt Fig. 1 die Situation nach Schritt e) in einem erfindungsgemäßen Verfahren dar.

Fig. 2a stellt einen erfindungsgemäßen Ring für die Oberflächenreinigung eines 200 mm Wafers mit entsprechenden Maßen dar.

Fig. 2b stellt die Situation dar, auf die der erfindungsgemäße Ring aufgebracht wird, nämlich den Querschnitt eines ringförmigen Rahmens, auf den eine Folie aufgespannt ist, die einen auflaminierten Wafer trägt. Der Innendurchmesser des Waferrahmens beträgt 243 - 250 mm.

Fig. 3 stellt zwei Alternativen des erfindungsgemäßen Ringes jeweils als Hälfte im Querschnitt dar. Dabei ist auf der linken Seite ein Ring mit einer Dichtfläche von einem mm (umlaufend) dargestellt, während auf der rechten Seite ein Ring dargestellt ist, der eine Aussparung 23 im unteren Bereich umfasst, die mit Unterdruck beaufschlagt werden kann.

In Fig. 1-3 bedeuten die Bezugszeichen folgendes:
- 1.: Ultraschallgeber
- 3.: Vertiefung mit Reinigungsmittel
- 5.: Ring
- 7.: Mechanische Fixierung des Ringes (und ggf. des Rahmens)
- 9.: Rahmen
- 11.: Folie
- 13.: Anlagestelle für Unterdruck
- 15.: Poröse Auflagefläche
- 17.: Zu reinigender Wafer (gedünnt)
- 19.: Dichtlippe
- 20.: O-Ring (umlaufend)
- 21.: Auflagefläche
- 23.: Aussparung für Unterdruck
- 25.: Aussparung für Rahmen
- 27.: Absaugkanal

In Fig. 1 ist ein einem Dünnungsverfahren unterzogen gewesener Wafer 17 einer Folie 11 auflaminiert, die auf einen Rahmen 9 gespannt ist. Diese Folie liegt auf einer porösen Auflagefläche 15 auf, an die ein Unterdruck 13 angelegt ist, so dass die Folie an der Auflagefläche fixiert und stabilisiert ist.

Der Ring 5 ist so angebracht, dass er um den Wafer 17 eine Vertiefung 3 bildet, in die ein Reinigungsmittel eingefüllt ist. Dabei ist die Dichtlippe 19 so angebracht, dass sie die Vertiefung gegen einen Austritt von Reinigungsmittel abdichtet.

Ein Ultraschallgeber 1 taucht in das Reinigungsmittel in der Vertiefung 3 ein. Durch Betrieb des Ultraschallgebers wird das Reinigungsmittel in Schwingung versetzt, so dass eine verstärkte Reinigung erfolgt. Auf diese Art kann die Reinigungsdauer verringert werden.

Der Ring 5 verfügt eine zum gedünnten Wafer hin abfallende Abschrägung. Diese ermöglicht es, das Reinigungsmittel nach der Einwirkzeit durch Abschleudern aus der Vertiefung zu entfernen. Hierzu wird die gesamte Vertiefung inklusive des Ringes und der porösen Auflagefläche (sowie ggf. weiterer Auflageflächebereiche) in Rotation versetzt, so dass durch die Fliehkraft das Reinigungsmittel aus der Vertiefung 3 geschleudert wird.

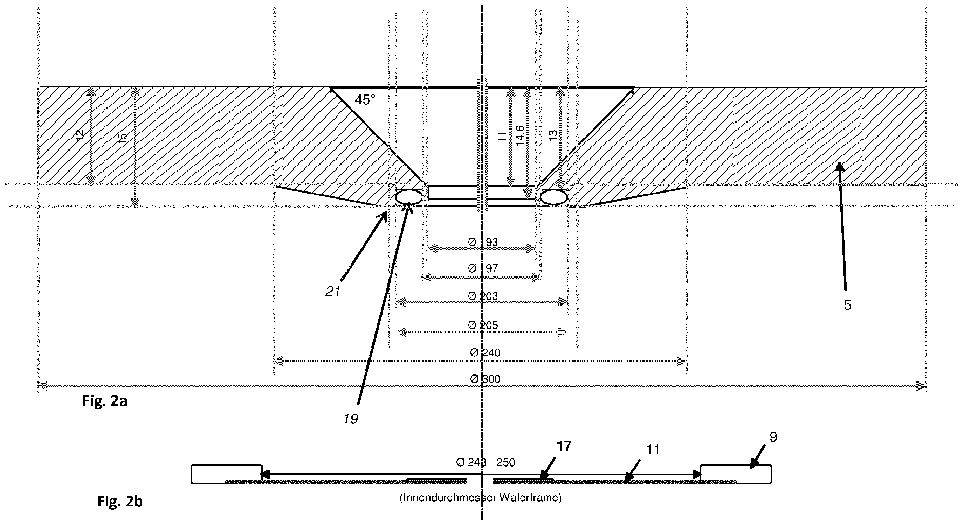

Fig. 2 zeigt schematisch eine alternative Ausgestaltungsform eines Ringes für eine Vertiefung bei der Behandlung eines 200 mm Wafers. In diesem Fall ist der Ring so ausgeführt, dass eine Abdichtung der Vertiefung zur Folie auf dem Wafer erfolgt. Dazu wird eine Nut in den Ring eingebracht, deren mittlerer Durchmesser kleiner als der äußere Durchmesser des Wafers ist. In diese Nut wird eine Dichtschnur eingebracht, die dann eine Abdichtung zwischen Ring und Wafer herstellt. Somit wird erreicht, dass die Reinigungsflüssigkeit in keiner Weise mit der Folie in Berührung kommt, was eine größere Flexibilität bei der Auswahl des Folienmaterials bedeutet

Die Größenangaben sind als Zahlenwerte (in mm) in die Figur eingetragen. Der in Fig. 2 abgebildete Dichtring 5 ist so ausgeführt, dass er im unteren Bereich der zur zur reinigenden Fläche abfallenden Schräge einen O-Ring 20 in einer Nut umfasst. Der O-Ring ist umlaufend. Dabei ist die Nut des O-Ringes 20 so gestaltet, dass die zum Ringinneren liegende Begrenzung höher als der tiefste Punkt der Unterseite des Ringes 5 ist. Den tiefsten Punkt der Unterseite stellt die Auflagefläche 21 dar. Die Auflagefläche 21 ist im Falle der Fig. 2 eine umlaufende Fläche von 1 mm Breite.

Der in Fig. 2 abgebildete Ring ist dabei so ausgestaltet, dass der O-Ring 20 in der Abdichtsituation auf dem Wafer zu liegen kommt, während die Auflagefläche 21 auf die Folie aufliegt, auf die der Wafer auflaminiert ist. Es ist aber auch möglich, die Auflagefläche 21 zusätzlich zum O-Ring auf dem Wafer aufliegen zu lassen.

Im Zusammenhang mit der Fig. 2 ist zu beachten, dass bevorzugt ist, dass die Auflagefläche 21 die tiefste Stelle der Unterseite des Ringes 5 ist.

Fig. 3 stellt auf der linken Seite eine verhältnismäßig einfache Version des erfindungsgemäßen Ringes 5 dar. Er besitzt eine Auflagefläche 21 mit einer umlaufenden Breite von einem 1mm. Ferner ist bei dem Ring 5 eine Aussparung 25 für den Rahmen vorgesehen. Wie aus der Fig. 3, linke Seite hervorgeht, ist eine Schräge vom inneren Ende der Aussparung 25 zur Auflagefläche 21 vorgesehen. Diese Schräge ist zum Ringinnneren hin abfallend ausgestaltet. Anstelle einer Schräge kann der Übergang allgemein auch durch eine oder mehrere Stufen erfolgen. In der Fig. 3 auf der rechten Seite ist für den erfindungsgemäßen Ring 5 eine Aussparung 23 für Unterdruck vorgesehen. Diese Aussparung 23 bildet einen umlaufenden Hohlraum, der über den Absaugkanal 27 mit Unterdruck beaufschlagt werden kann. Auch dieser Ring 5 umfasst eine Aussparung 25 für den Rahmen.

Bei Beaufschlagung mit Unterdruck wird durch die Aussparung 23 für Unterdruck eine entsprechende Ansaugkraft des Ringes an der Unterlage erzeugt. Somit ist eine Abdichtung gewährleistet. Als Alternative zum Ansaugkanal 27 ist es auch möglich, die Abdichtung zu gewährleisten, wenn die Unterlage, auf die der Ring 5 aufgelegt wird, porös ist und mit Unterdruck beaufschlagt werden kann, so dass der Ring auf der Unterlage angesaugt wird. Dies wäre z. B. möglich, wenn die Folie, auf die der Wafer auflaminiert ist, perforiert ist. Für diese Form der Abdichtung ist es nicht nötig, dass eine Aussparung 23 vorgesehen ist.

## Patentansprüche

1. Verfahren zum Behandeln einer Fläche auf einem Wafer (17) oder einem Mikroplättchen, umfassend die Schritte:
a) Bereitstellen eines Wafers (17) oder eines Mikroplättchens,
b) Platzieren des Wafers (17) oder des Mikroplättchens auf einer Unterlage (11),
c) Bereitstellen von Material für eine umlaufende Begrenzung um die zu behandelnde Fläche,
d) Anbringen des Materials für die umlaufende Begrenzung so, dass um die zu behandelnde Fläche eine Vertiefung (3) entsteht, aus der eine Flüssigkeit nicht austreten kann und
e) Befüllen der Vertiefung mit einer Behandlungsflüssigkeit,
wobei die Behandlung eine Reinigung und das Entfernen von Behandlungsflüssigkeit durch Abschleudern umfasst, **dadurch gekennzeichnet,**
**dass** das Material für die umlaufende Begrenzung nach Schritt d) so angebracht ist, dass eine vom oberen Rand der Begrenzung zur reinigenden Fläche abfallende Schräge vorhanden ist,
wobei die Vertiefung so ausgestaltet ist, dass ihr Boden vollständig durch den Wafer (17) oder das Mikroplättchen gebildet wird.

2. Verfahren nach Anspruch 1, wobei das Material für die umlaufende Begrenzung einen Ring (5) darstellt.

3. Verfahren nach einem der Ansprüche 1 bis 2, wobei die Behandlungswirkung der Behandlungsflüssigkeit durch Vibration und/oder durch Erwärmung der Behandlungsflüssigkeit verbessert wird.

4. Verfahren nach einem der Ansprüche 1 bis 3, wobei die Reinigungswirkung durch einen Ultraschallgeber (1), der in die Behandlungsflüssigkeit nach Schritt e) eintaucht, unterstützt wird.

5. Verfahren nach einem der Ansprüche 1 bis 4, umfassend das Entfernen von Behandlungsflüssigkeit durch Absaugen und/oder Ablassen.

6. Vorrichtung, eingerichtet zur Durchführung eines Verfahrens nach einem der Ansprüche 1 bis 5.

## Claims

1. Method of treating a surface on a wafer (17) or a die comprising the steps of:
(a) providing a wafer (17) or a die,
(b) placing the wafer (17) or the die on a support (11),
(c) providing material for forming a boundary surrounding the surface to be treated,
(d) applying the material for the surrounding boundary in such a way that a depression (3) is formed around the surface to be treated from which a liquid is unable to escape
(e) filling the depression with a treatment liquid,
wherein the treatment comprises cleaning and removal of treatment liquid by centrifuging, **characterised in that** the material for the surrounding boundary according to step d) is applied in such a way that a bevel exists which slopes down from the top edge of the boundary to the surface intended for cleaning, wherein the depression is so designed such that its floor is completely formed by the wafer (17) or the die.

2. Method according to claim 1, wherein the material for the surrounding boundary forms a ring (5).

3. Method according to any one of claims 1 to 2, wherein the treating effect of the treatment liquid is improved by vibration and/or by heating the treatment liquid.

4. Method according to any one of claims 1 to 3, wherein the cleaning effect is supported by an ultrasound emitter (1) which dips into the treatment liquid according to step e).

5. Method according to any one of claims 1 to 4, comprising the removal of treatment liquid by suction and/or draining.

6. Apparatus designed to carry out a method according to any one of claims 1 to 5.

## Revendications

1. Procédé pour traiter une surface sur une tranche (17) ou une microplaquette, comprenant les étapes :
a) de fourniture d'une tranche (17) ou d'une microplaquette,
b) de placement de la tranche (17) ou de la microplaquette sur un support (11),
c) de fourniture de matériau pour une délimitation périphérique autour de la surface à traiter,
d) d'application du matériau pour la délimitation périphérique de telle sorte que se forme autour de la surface à traiter un renfoncement (3) duquel un liquide ne peut pas sortir, et
e) de remplissage du renfoncement avec un liquide de traitement,
dans lequel le traitement comprend un nettoyage et l'élimination du liquide de traitement par essorage, **caractérisé en ce**
**que** le matériau pour la délimitation périphérique est installé selon l'étape d) de telle sorte qu'un chanfrein descendant depuis le bord supérieur de la délimitation vers la surface à nettoyer est présent, dans lequel le renfoncement est configuré de telle sorte que son fond est formé en totalité par la tranche (17) ou la microplaquette.

2. Procédé selon la revendication 1, dans lequel le matériau pour la délimitation périphérique constitue une bague (5).

3. Procédé selon l'une quelconque des revendications 1 à 2, dans lequel l'action de traitement du liquide de traitement est améliorée par vibration et/ou par réchauffement du liquide de traitement.

4. Procédé selon l'une quelconque des revendications 1 à 3, dans lequel l'action de nettoyage est soutenue par un émetteur d'ultrasons (1) qui plonge dans le liquide de traitement selon l'étape e).

5. Procédé selon l'une quelconque des revendications 1 à 4, comprenant l'élimination du liquide de traitement par évacuation par aspiration et/ou par évacuation par soutirage.

6. Dispositif mis au point pour mettre en œuvre un procédé selon l'une quelconque des revendications 1 à 5.
